# EUROPEAN PATENT SPECIFICATION

(11) **EP 2 273 862 B1**
(45) Date of publication and mention of the grant of the patent: **05.08.2020**
(21) Application number: 09735005.2
(22) Date of filing: 21.04.2009
(51) Int. Cl.: H05K 9/00, H01L 23/36, H02M 7/48, H05K 7/20

(54) **UNIT WITH POWER CIRCUIT MOUNTED THEREIN, AND MOTOR DRIVE APPARATUS**
EINHEIT MIT DARIN MONTIERTEM STROMKREIS UND ANTRIEBSGERÄT
UNITÉ MUNIE D UN CIRCUIT DE PUISSANCE ET APPAREIL D'ENTRAÎNEMENT DE MOTEUR

(30) Priority: 24.04.2008 JP 2008113661
(43) Date of publication of application: 12.01.2011
(73) Proprietor: Daikin Industries, Ltd., Osaka-shi, Osaka 530-8323 (JP)
(72) Inventor: ISHIZEKI, Shinichi, Sakai-shi Osaka 591-8511 (JP); SATOU, Toshiaki, Kusatsu-shi Shiga 525-8526 (JP)
(74) Representative: Hoffmann Eitle
(86) International application number: PCT/JP2009/001818
(87) International publication number: WO 2009/130890

(56) References cited:
- JP-A- 5 328 710
- JP-A- 7 087 739
- JP-A- 11 069 774
- JP-A- 11 097 874
- JP-A- 2004 022 705
- JP-A- 2006 115 649
- JP-A- 2007 266 527
- US-A1- 2003 042 624
- US-B1- 6 215 679

## Description

### TECHNICAL FIELD

The present invention relates to a power circuit mount unit in which power modules are mounted on a substrate, and is particularly for reducing noise caused due to a switching operation in the power module.

### BACKGROUND ART

Conventionally, a power circuit mount unit including a power module has been applied to, e.g., a drive apparatus of a motor of a compressor.

Patent Document 1 discloses the power circuit mount unit of this type. In the power circuit mount unit, a power module including switching elements is mounted on a substrate. A heat sink for dissipating heat to cool the power module is provided in the power circuit mount unit.

In addition, Patent Document 2 discloses that a heat sink is attached to a surface of a power module. Heat generated in a switching element is conducted to the heat sink, and then is dissipated to air through a heat dissipating fin. This reduces or prevents an erroneous switching caused due to heat accumulation in the power module.

Further, JP 7 087739 A discloses a switching power supply apparatus which shields the coupling of electromagnetic waves to a switching control circuit from a primary-side switching circuit and a secondary-side switching circuit by a heat-dissipating means which heat-dissipates a self-switching loss and an influence given to a switching control circuit by electromagnetic-wave noises is reduced by a simple structure.

Electric power which is input to a primary-side input terminal is converted into a DC power-supply voltage by a primary-side power-supply circuit, and it is converted into high-frequency electric power by a primary-side switching element for a heat sink. Then, the high-frequency electric power is insulated and transformed by an electric-power transfer part, and it is converted into DC electric power by a secondary-side switching element. The DC electric power is smoothed by a secondary-side smoothing circuit, and it is output to a secondary-side output terminal. A switching control circuit feeds back a secondary- side output in such a way that the output of the secondary-side output terminal becomes definite, and it controls the continuity of the primary-side switching element. The switching control circuit 9 is housed inside the space of the heat sink, and it shields electromagnetic-wave noises from the primary-side and secondary-side switching elements and from a peripheral circuit.

US 6 215 679 B1 discloses an alternator having a small size and a high reliability wherein, the alternator is equipped with a switching power module having a resin case housing switching elements and a driving circuit section, a smoothing capacitor for smoothing a direct current output supplied to the switching elements, a control circuit section for outputting a control signal to the driving circuit section and a cooling member; a ceramic capacitor is used as the smoothing capacitor; a smoothing capacitor board for mounting the smoothing capacitor is disposed between an insulating board mounting with the switching elements and a driving circuit board mounting with the driving circuit section; and the smoothing capacitor board functions also as an electromagnetic shielding plate for protecting the driving circuit section against the switching noise of the switching elements.

JP 2007 266527 A discloses a control substrate which is connected to a columnar support via a fixing bracket. Likewise, a GND pattern of the control substrate is also connected to the columnar support via the fixing bracket. Here, the columnar support and the fixing bracket are made of aluminum; thus, their thermal conductivity is superior. Furthermore, the GND pattern is of aluminum or copper; thus, its thermal conductivity is satisfactory. In other words, the control substrate is thermally connected to a cooling plate 12 via the columnar support and the fixing bracket. In short, heat generated from control parts on the control substrate is conducted to the cooling plate from the GND pattern via the fixing bracket and the columnar support. This mechanism enables an inverter device for a vehicle to efficiently conduct heat generated on the control substrate to the cooling plate, thus dissipating the heat to the outside.

US 2003/042624 discloses a power semiconductor device having a power element sealed into a package, which comprises the package, the power element fixed in the package, a bonding wire connected to the power element, and a gel insulator for covering the power element, characterized in that foam material is further charged so as to fill a cavity left inside of said package.

JP 2004 022705 A discloses a solution to the problem wherein electromagnetic shielding effect is deteriorated, since the distance between an electromagnetic shielding panel and a relay terminal is increased, when a breakdown voltage is secured between both of the members in a power module provided with a power semiconductor device is provided with the electromagnetic shielding panel for cutting-off electromagnetic noise produced during switching operation of the power semiconductor device. SOLUTION: By interposing an insulating material between the electromagnetic shielding panel and the relay terminal, the breakdown voltage force between both of the members become strong, and as a result, the distance between both the members can be reduced, so that the electromagnetic shielding effect is improved.

### CITATION LIST

### PATENT DOCUMENT

PATENT DOCUMENT 1: Japanese Patent Publication No. 2007-311529 25
PATENT DOCUMENT 2: Japanese Patent Publication No. 06-252282

### SUMMARY OF THE INVENTION

### TECHNICAL PROBLEM

It has been known that a detection circuit for detecting output voltage or output current to the motor is provided in the motor drive apparatus etc. in order to control, e.g., a rotational speed of the motor which is a load. If such detection circuit is mounted on the substrate of the power circuit mount unit, noise may be superimposed on a detected signal of the detection circuit.

Specifically, when performing a switching operation in the switching element of the power module, the potential of the heat sink attached to the power module is varied. Thus, in the heat sink, electromagnetic waves are generated due to the potential variation. This causes a disadvantage that, in the detection circuit arranged near the heat sink, noise is superimposed on the detected signal due to the electromagnetic waves from the heat sink, resulting in a detection error.

The present invention has been made in view of foregoing, and it is an object of the present invention to, in a power circuit mount unit in which power modules and detection circuits are mounted on a substrate, reduce or prevent a detection error in a detection circuit due to electromagnetic waves from a heat sink.

### SOLUTION TO THE PROBLEM

A power circuit mount unit according to the present invention is defined by claim 1. Dependent claims relate to preferred embodiments. A motor drive apparatus according to the present invention is defined by claim 7.

The power circuit mount unit includes a substrate (P) on which a power module (51, 52) is mounted; a heat sink (53) for dissipating heat from the power modules (51, 52), which is attached to surfaces of the power modules (51, 52); a detection circuit (60) for detecting predetermined current or voltage, which is mounted near the power modules (51, 52) on the substrate (P), the power circuit mount unit; and an electromagnetic shielding member (70) for shielding against electromagnetic waves generated from the heat sink (53) to the detection circuit (60) side.

The power modules (51, 52) and the detection circuit (60) are mounted on the substrate (P). The detection circuit (60) detects current or voltage in a predetermined circuit on the substrate (P). When performing a switching operation in the power module (51, 52), the potential of the heat sink (53) is varied, thereby generating electromagnetic waves from the heat sink (53). In the present invention, the electromagnetic waves generated from the heat sink (53) are shielded by the electromagnetic shielding member (70), thereby reducing an influence of the electromagnetic waves in the detection circuit (60). Consequently, in the detection circuit (60), superimposition of noise on a detected signal due to the electromagnetic waves can be reduced.

The detection circuit (60) is arranged so as to face the heat sink (53) with the substrate (P) being interposed between the detection circuit (60) and the heat sink (53), and the electromagnetic shielding member (70) is provided between an attachment section (60a) of the detection circuit (60) of the substrate (P) and the heat sink (53).

The detection circuit (60) is arranged so as to face the heat sink (53) with the substrate (P) being interposed therebetween. That is, if a heat dissipating area is expanded, and the packing density of the detection circuit (60), the power modules (51, 52), etc. is reduced, a positional relationship is attained, in which the detection circuit (60) and the heat sink (53) face each other with the substrate (P) being interposed therebetween. In such a positional relationship, the detection circuit (60) is susceptible to the electromagnetic waves generated from the heat sink (53). However, in the present invention, the electromagnetic shielding member (70) is provided between the attachment section (60a) of the detection circuit (60) of the substrate (P) and the heat sink (53), and therefore the electromagnetic shielding member (70) can ensure shielding against the electromagnetic waves from the heat sink (53) side to the detection circuit (60) side. Consequently, in the detection circuit (60), the superimposition of noise on the detected signal due to the electromagnetic waves can be effectively reduced.

According to preferred embodiments, the electromagnetic shielding member (70) is a conductive plate held at ground potential.

The electromagnetic shielding member (70) is the conductive plate held at ground potential. This effectively reduces the influence of the electromagnetic waves from the heat sink (53), and an influence of noise in the detection circuit (60).

According to preferred embodiments, the power circuit mount unit further includes a conductive support member (72) for supporting the electromagnetic shielding member (70) on the substrate (P). The electromagnetic shielding member (70) is connected to ground of the substrate (P) through the support member (72).

The electromagnetic shielding member (70) is supported by the substrate (P) through the support members (72). The support member (72) is made of conductive material, and allows conduction between the electromagnetic shielding member (70) and the ground of the substrate (P). Thus, the holding of the electromagnetic shielding member (70) at a predetermined position can be ensured, and wiring for grounding the electromagnetic shielding member (70) can be simplified.

According to preferred embodiments, the electromagnetic shielding member (70) is a conductive plate held at control ground potential of the substrate (P) .

The conductive plate is held at control ground potential of the substrate (P). This effectively reduces the influence of the electromagnetic waves from the heat sink (53), and the influence of noise in the detection circuit (60).

According to preferred embodiments, the power module (51, 52) includes switching elements (41-46) of an inverter circuit (40) for converting DC voltage into AC voltage.

According to preferred embodiments, the electromagnetic shielding member (70) shields against the electromagnetic waves generated from the heat sink (53) in response to the switching operation of the switching element (41-46) of the inverter circuit (40) .

According to preferred embodiments, the power module (51, 52) includes switching elements (21-26) of a rectifier circuit (20) for rectifying AC voltage of an AC power source (S) into DC voltage.

The electromagnetic shielding member (70) shields against the electromagnetic waves generated from the heat sink (53) in response to the switching operation of the switching element (21 - 26) of the rectifier circuit (20).

The invention also relates to a motor drive apparatus for driving a motor (M), which includes a power circuit mount unit (50) of any one of the previously discussed embodiments, and a motor control section (12) for controlling the motor (M) based on a current value or a voltage value detected in a detection circuit (60) mounted on a substrate (P) of the power circuit mount unit (50) .

The power circuit mount unit (50) in accordance with any one of the previously mentioned embodiments is installed in the mentioned motor drive apparatus. The detection circuit (60) detects output current or output voltage to the motor (M) which is a load. The power circuit mount unit (50) shields against the electromagnetic waves from the heat sink (53) side to the detection circuit (60) side, thereby reducing an erroneous detection in the detection circuit (60). Consequently, the motor control section (12) can properly control the motor (M) based on the current value or the voltage value detected in the detection circuit (60).

### ADVANTAGES OF THE INVENTION

In the present invention, the electromagnetic waves from the heat sink (53) side to the detection circuit (60) side are shielded by the electromagnetic shielding member (70). This reduces or prevents irradiation of noise into the detection circuit (60) due to the electromagnetic waves, thereby reducing or preventing the erroneous detection in the detection circuit (60). Thus, a power circuit mount unit with excellent reliability can be provided.

Further, the detection circuit (60) and the heat sink (53) are arranged so as to face each other with the substrate (?) being interposed therebetween, and the electromagnetic shielding member (70) is provided between the attachment section (60a) of the detection circuit (60) of the substrate (?) and the heat sink (53). This ensures the shielding of the detection circuit (60) against the electromagnetic waves generated from the heat sink (53), thereby reducing the influence of noise. In addition, such a positional relationship allows the heat sink (53) to extend in a direction along the substrate (P), resulting in the expansion of the heat dissipating area. Further, the detection circuit (60) can be adjacent to the power modules (51, 52), thereby properly exchanging a signal between the detection circuit (60) and the power module (51, 52).

According to preferred embodiments, the electromagnetic shielding member (70) is the conductive plate held at ground potential, thereby effectively shielding against the electromagnetic waves from the heat sink (53). In particular, according to preferred embodiments, the electromagnetic shielding member (70) is connected to the ground of the substrate (P) through the conductive support members (72). Thus, a support structure of the electromagnetic shielding member (70) and wiring for connecting to ground can be simplified, and therefore the power circuit mount unit can be simplified.

According to preferred embodiments, the electromagnetic shielding member (70) is the conductive plate held at control ground potential, thereby effectively shielding against the electromagnetic waves from the heat sink (53).

### BRIEF DESCRIPTION OF THE DRAWINGS

[FIG. 1] FIG. 1 is a circuit diagram schematically illustrating a configuration of a motor drive apparatus of an embodiment.
[FIG. 2] FIG. 2 is an enlarged cross-sectional view of a main section of a power circuit mount unit of the embodiment.

### DESCRIPTION OF EMBODIMENTS

Embodiments of the present invention will be described in detail hereinafter with reference to the drawings.

A power circuit mount unit (50) of the present invention is installed in a motor drive apparatus (10) for driving a motor (M) of a compressor. The compressor is connected to a refrigerant circuit of an air conditioning system, and the motor (M) is a DC brushless motor. The motor drive apparatus (10) is accommodated together with the compressor and an outdoor fan in an outdoor unit of the air conditioning system.

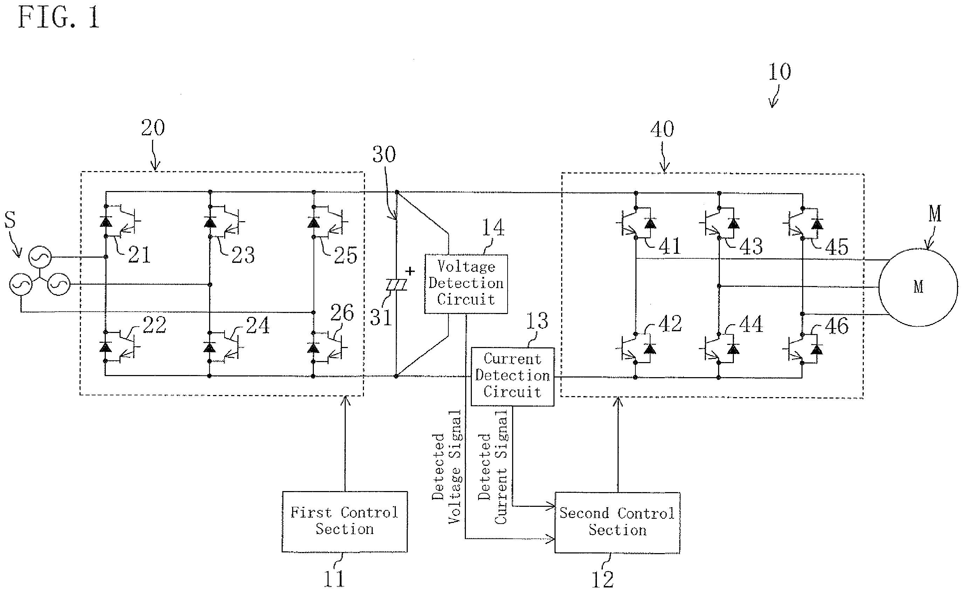

As illustrated in FIG. 1, the motor drive apparatus (10) includes a rectifier circuit (20); a capacitor circuit (30); and an inverter circuit (40).

The rectifier circuit (20) is connected to a commercial power source (S) which is a three-phase AC power source. The rectifier circuit (20) is for converting AC voltage of the commercial power source (S) into DC voltage. In the rectifier circuit (20), six switching elements (21-26) are connected together to form a three-phase bridge circuit. In the rectifier circuit (20), a first control section (11) controls a switching (ON/OFF) of each of the switching elements (21-26), resulting in generation of DC voltage, improvement of a power factor, and reduction in harmonics.

The capacitor circuit (30) is connected to an output side of the rectifier circuit (20). A capacitor (31) for charging/discharging the output of the rectifier circuit (20) is connected to the capacitor circuit (30).

The inverter circuit (40) is for converting DC voltage of the capacitor (31) into three-phase AC voltage, and supplying the converted DC voltage to the motor (M) which is a load. In the inverter circuit (40), six switching elements (41-46) are connected together to form a three-phase bridge circuit. In the inverter circuit (40), a second control section (12) controls a switching of the switching element (41-46), thereby adjusting an output torque and a rotational speed of the motor (M).

The motor drive apparatus (10) includes a current detection circuit (13) and a voltage detection circuit (14). The current detection circuit (13) detects output current from the capacitor circuit (30) side to the inverter circuit (40). The voltage detection circuit (14) detects output voltage from the capacitor circuit (30) side to the inverter circuit (40). That is, the current detection circuit (13) serves as a detection circuit for detecting output current of the motor (M), and the voltage detection circuit (14) serves as a detection circuit for detecting output voltage of the motor (M).

The second control section (12) serves as a motor control section for controlling the motor (M) based on a current value detected in the current detection circuit (13) and a voltage value detected in the voltage detection circuit (14). Specifically, the second control section (12) obtains an actual speed (rotational speed) and a phase (rotational angular position) of the motor (M) based on a detected current signal from the current detection circuit (13), and then outputs a drive signal for controlling the motor (M) at a desired actual speed. In the inverter circuit (40), a gate drive circuit (not shown in the figure) to which the drive signal is inputted controls the ON/OFF of each of the switching elements (41-46), thereby adjusting an operational frequency of the motor (M). In addition, in the second control section (12), a protection control of the motor (M) is performed based on a detected voltage signal from the voltage detection circuit (14) and the detected current signal from the current detection circuit (13).

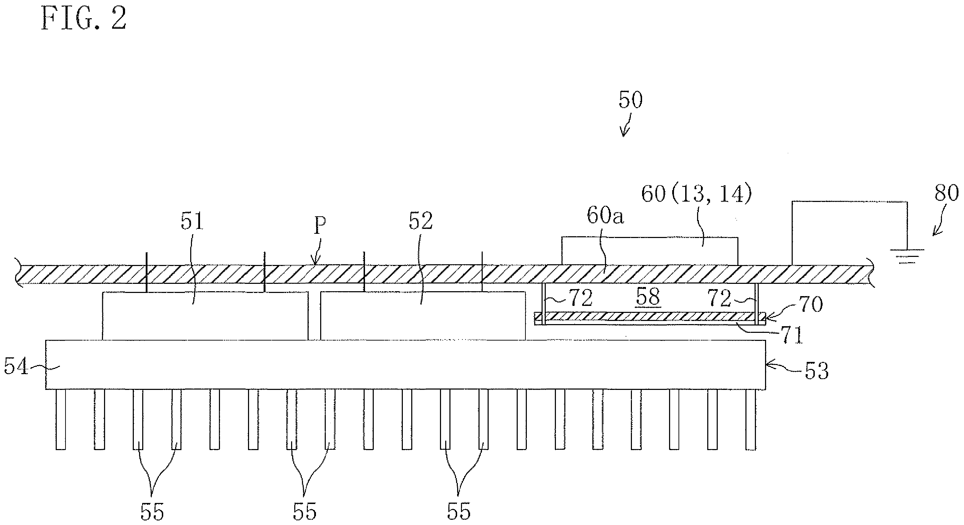

As illustrated in FIG. 2, the power circuit mount unit (50) includes a printed circuit board (P). A first power module (51) and a second power module (52) are mounted on the printed circuit board (P). The first power module (51) includes the switching elements (21-26) on the rectifier circuit (20) side. The second power module (52) includes the switching elements (41-46) on the inverter circuit (40) side. The switching elements (21-26, 41-46) of the first power module (51) and the second power module (52) are power semiconductor elements, and, e.g., MOS-FETs and IGBTs are used.

The first power module (51) and the second power module (52) are mounted on one surface (a lower surface as viewed in FIG. 2) of the printed circuit board (P). A heat sink (53) for dissipating heat from the power module (51, 52) is attached to surfaces of the first power module (51) and the second power module (52). The outdoor fan is arranged near the heat sink (53). That is, the heat sink (53) is cooled with air sent by the outdoor fan.

The heat sink (53) includes a base (54); and a plurality of fins (55) vertically arranged on a surface of the base (54). The base (54) is formed in a plate-like shape extending along the printed circuit board (P). In addition, the base (54) is arranged so as to extend across both of the first power module (51) and the second power module (52).

Specifically, the base (54) of the heat sink (53) outwardly protrudes beyond side edges of the power modules (51, 52). That is, an area of an end surface of the base (54) in a thickness direction is larger than an area where the first power module (51) and the second power module (52) contact the base (54), thereby expanding an area where heat is dissipated. Thus, a space (58) is formed between the printed circuit board (P) and the heat sink (53) on a back side of the base (54) of the heat sink (53).

A detection circuit (60) is mounted on a surface of the printed circuit board (P), which is on an opposite side to the surface to which the power modules (51, 52) are attached. The detection circuit (60) includes the current detection circuit (13) and the voltage detection circuit (14). The detection circuit (60) is arranged near an attachment section of the first power module (51) and the second power module (52). Consequently, the detection circuit (60) is arranged in a position overlapping with the base (54) of the heat sink (53) in a thickness direction of the printed circuit board (P). That is, a positional relationship is attained, in which the detection circuit (60) and the heat sink (53) face each other with the printed circuit board (P) being interposed therebetween.

In the present embodiment, an electromagnetic shielding member (70) for shielding against electromagnetic waves from the heat sink (53) side to the detection circuit (60) side is provided between the base (54) of the heat sink (53) and the printed circuit board (P). The electromagnetic shielding member (70) is formed in a plate-like shape extending along the base (54) of the heat sink (53) and the printed circuit board (P). The electromagnetic shielding member (70) is provided between the base (54) of the heat sink (53) and the attachment section (60a) of the detection circuit (60) of the printed circuit board (P). That is, in the power circuit mount unit (50), the base (54) of the heat sink (53), the electromagnetic shielding member (70), the printed circuit board (P), and the detection circuit (60) are arranged in this order so as to overlap with each other in the thickness direction of the printed circuit board (P).

The electromagnetic shielding member (70) is a printed circuit board on which a solid ground plane is formed. The electromagnetic shielding member (70) is arranged so that a solid ground plane section (71) faces the heat sink (53) side. Note that the solid ground plane section (71) may be arranged so as to face an opposite side, or may be arranged on both sides. In addition, the electromagnetic shielding member (70) is supported by the printed circuit board (P) through a plurality of conductive ground pins (72). That is, the electromagnetic shielding member (70) is electrically connected to ground (80) of the printed circuit board (P) through the solid ground plane section (71) and the ground pins (72). Thus, the electromagnetic shielding member (70) is a conductive plate held at ground potential. The electromagnetic shielding member (70) supported by the ground pins (72) is apart from the base (54) of the heat sink (53), and the attachment section (60a) of the detection circuit (60) of the printed circuit board (P) by approximately several millimeters.

The electromagnetic shielding member (70) is arranged as described above, and therefore irradiation of noise into the detection circuit (60) due to the electromagnetic waves generated from the heat sink (53) side is reduced. That is, in a conventional power circuit mount unit, the potential of the heat sink (53) is varied in response to switching operations of the switching element (21-26) of the first power module (51) and of the switching element (41-46) of the second power module (52), thereby generating the electromagnetic waves from the heat sink (53). On the other hand, in the power circuit mount unit (50) of the present embodiment, the electromagnetic shielding member (70) inserted between the detection circuit (60) and the heat sink (53) shields against the electromagnetic waves from the heat sink (53), thereby reducing noise due to the electromagnetic waves in the detection circuit (60). Consequently, in the detection circuit (60), a detection error of the current value and the voltage value can be reduced or prevented, and a suitable detected signal can be outputted from the detection circuit (60).

### Advantages of Embodiment

In the foregoing embodiment, the electromagnetic waves from the heat sink (53) side to the detection circuit (60) side is shielded by the electromagnetic shielding member (70). This reduces or prevents the irradiation of noise into the detection circuit (60) due to the electromagnetic waves, and an erroneous detection in the detection circuit (60). Thus, in the second control section (12), e.g., the rotational speed of the motor (M) can be properly adjusted based on the current value detected in the detection circuit (60), and the proper protection control of the motor (M) can be performed based on the voltage value detected in the detection circuit (60).

In the foregoing embodiment, the heat sink (53) outwardly protrudes beyond the side edges of the power modules (51, 52), thereby expanding the heat dissipating area. The electromagnetic shielding member (70) is provided in the space (58) between the base (54) of the heat sink (53) and the attachment section (60a) of the detection circuit (60) of the printed circuit board (P). This ensures shielding of the detection circuit (60) against the electromagnetic waves in the substrate thickness direction, which are generated from the heat sink (53), thereby reducing an influence of noise. Further, the space (58) can be effectively used as an installation space of the electromagnetic shielding member (70).

The detection circuit (60) and the power modules (51, 52) can be adjacent to each other, thereby properly exchanging a signal between the detection circuit (60) and the power module (51, 52).

The electromagnetic shielding member (70) is the conductive plate held at ground potential, thereby effectively shielding against the electromagnetic waves from the heat sink (53). Further, the electromagnetic shielding member (70) is connected to the ground side of the substrate (P) through the conductive support members (72), and therefore a support structure of the electromagnetic shielding member (70) and wiring for connecting to ground can be simplified.

The electromagnetic shielding member (70) is the printed circuit board including the solid ground plane section (71), thereby obtaining an electromagnetic shielding member by using a general printed circuit board.

### «Other Embodiments»

The foregoing embodiment may have the following configurations.

In the foregoing embodiment, the detection circuit (60) and the heat sink (53) are arranged so as to face each other with the printed circuit board (P) being interposed therebetween. However, the detection circuit (60) may be arranged so as to be displaced from the heat sink (53) as viewed in the substrate thickness direction. In such a case, noise may be irradiated into the detection circuit (60) due to the electromagnetic waves generated from the heat sink (53), but the electromagnetic shielding member (70) can reduce the influence of the electromagnetic waves.

In the foregoing embodiment, the electromagnetic shielding member (70) is connected to ground on the printed circuit board (P) side. However, a ground wire may be directly connected to the electromagnetic shielding member (70) to hold the electromagnetic shielding member (70) at ground potential.

The electromagnetic shielding member (70) may be connected to control ground of the printed circuit board (P) through the ground wire to hold the electromagnetic shielding member (70) at control ground potential. In such a case, as in the foregoing description, the electromagnetic shielding member (70) can reduce the influence of the electromagnetic waves.

The electromagnetic shielding member (70) is not necessarily held at ground potential, and the base (54) of the heat sink (53) may be covered with, e.g., electric shielding material containing magnetic material and resin material, to shield against electromagnetic waves. Besides holding the electromagnetic shielding member (70) at ground potential of the printed circuit board (P), advantages of the present invention can be obtained by, e.g., holding the electromagnetic shielding member (70) at control ground potential.

In the foregoing embodiment, both of the current detection circuit (13) and the voltage detection circuit (14) are used as the detection circuit (60), but the present invention is applicable to a detection circuit for detecting either one of current and voltage. In addition, the detection circuit (60) does not necessarily detect the output current or the output voltage to the motor (M), but may detect, e.g., input current or input voltage to a predetermined circuit on the substrate. Further, the detection circuit (60) may be provided on a side of the printed circuit board (P), to which the power module (51, 52) is attached, or may be provided on both sides of the printed circuit board (P).

In the power circuit mount unit (50) of the foregoing embodiment, both of the power module (51) on the rectifier circuit (20) side and the power module (52) on the inverter circuit (40) side are mounted on the printed circuit board (P). However, the present invention is applicable when either one of the power modules (51, 52) is mounted on the printed circuit board (P).

The power module (51, 52) does not necessarily include the plurality of switching elements, and may include only a single switching element. Specifically, the present invention is applicable to a rectifier circuit which includes a single switching element, and in which a diode bridge is combined with a boost chopper.

In the foregoing embodiment, the power circuit mount unit of the present invention is applied to the motor drive apparatus for driving the motor (M) of the compressor.

However, the present invention may be applied to, e.g., a power circuit mount unit in which a motor of an outdoor fan or an indoor fan of an air conditioning system is a load, or may be applied to a power circuit mount unit which is intended for a component other than the motor (M) as a load.

The foregoing embodiments have been set forth merely for purposes of preferred examples in nature, and are not intended to limit the scope, applications, and use of the invention.

### INDUSTRIAL APPLICABILITY

As described above, the present invention relates to the power circuit mount unit including the power modules, and is particularly useful for reducing noise caused due to the switching operation in the power module.

### DESCRIPTION OF REFERENCE CHARACTERS

- 12: Second Control Section (Motor Control Section)
- 50: Power Circuit Mount Unit
- 51: First Power Module (Switching Element)
- 52: Second Power Module (Switching Element)
- 53: Heat Sink
- 60: Detection Circuit (Current Detection Circuit, Voltage Detection Circuit)
- 70: Electromagnetic Shielding Member
- 72: Ground Pin (Support Member)
- P: Printed Circuit Board (Substrate)
- S: AC Power Source
- M: Motor

## Claims

1. A power circuit mount unit, comprising:
a substrate (P) on which a power module (51, 52) is mounted;
a heat sink (53) for dissipating heat from the power modules (51, 52), which is attached to surfaces of the power modules (51, 52);
a detection circuit (60) for detecting predetermined current or voltage, which is mounted near the power modules (51, 52) on the substrate (P), the power circuit mount unit; and
an electromagnetic shielding member (70) for shielding against electromagnetic waves generated from the heat sink (53) to the detection circuit (60) side,
**characterized in that**:
the detection circuit (60) is arranged so as to face the heat sink (53) with the substrate (P) being interposed between the detection circuit (60) and the heat sink (53); and
the electromagnetic shielding member (70) is provided between an attachment section (60a) of the detection circuit (60) of the substrate (P) and the heat sink (53).

2. The power circuit mount unit of claim 1, wherein
the electromagnetic shielding member (70) is a conductive plate held at ground
potential.

3. The power circuit mount unit of claim 1 or 2, further comprising:
a conductive support member (72) for supporting the electromagnetic shielding member (70) on the substrate (P),
wherein the electromagnetic shielding member (70) is connected to ground of the substrate (P) through the support member (72).

4. The power circuit mount unit of claim 1, wherein the electromagnetic shielding member (70) is a conductive plate held at control ground potential of the substrate (P).

5. The power circuit mount unit of any one of claims 1-4, wherein
the power module (51, 52) includes switching elements (41-46) of an inverter
circuit (40) for converting DC voltage into AC voltage.

6. The power circuit mount unit of any one of claims 1 -5, wherein
the power module (51, 52) includes switching elements (21-26) of a rectifier circuit 15 (20) for rectifying AC voltage of an AC power source (S) into DC voltage.

7. A motor drive apparatus for driving a motor (M), comprising:
a power circuit mount unit (50) of any one of claims 1-6; and
a motor control section (12) for controlling the motor (M) based on a current value 20 or a voltage value detected in a detection circuit (60) mounted on a substrate (P) of the power circuit mount unit (50)

## Patentansprüche

1. Stromkreismontageeinheit, umfassend:
ein Substrat (P), auf dem ein Strommodul (51, 52) montiert ist;
eine Wärmesenke (53) zum Abführen von Wärme von den Strommodulen (51, 52), die an Oberflächen der Strommodule (51, 52) befestigt ist;
eine Detektionsschaltung (60) zum Detektieren von vorbestimmtem Strom oder Spannung, die in der Nähe der Strommodule (51, 52) auf dem Substrat (P) der Stromkreismontageeinheit montiert ist; und
ein elektromagnetisches Abschirmelement (70) zum Abschirmen vor elektromagnetischen Wellen, die von der Wärmesenke (53) zu der Seite der Detektionsschaltung (60) erzeugt werden,
**dadurch gekennzeichnet, dass**:
die Detektionsschaltung (60) so angeordnet ist, dass sie zu der Wärmesenke (53) zeigt, wobei das Substrat (P) zwischen der Detektionsschaltung (60) und der Wärmesenke (53) eingesetzt ist; und
das elektromagnetische Abschirmelement (70) zwischen einem Befestigungsbereich (60a) der Detektionsschaltung (60) des Substrats (P) und der Wärmesenke (53) bereitgestellt ist.

2. Stromkreismontageeinheit nach Anspruch 1,
wobei das elektromagnetische Abschirmelement (70) eine leitende Platte ist, die auf Erdpotential gehalten wird.

3. Stromkreismontageeinheit nach Anspruch 1 oder 2, weiter umfassend:
ein leitendes Stützelement (72) zum Stützen des elektromagnetischen Abschirmelements (70) auf dem Substrat (P),
wobei das elektromagnetische Abschirmelement (70) über das Stützelement (72) mit der Erde des Substrats (P) verbunden ist.

4. Stromkreismontageeinheit nach Anspruch 1, wobei
das elektromagnetische Abschirmelement (70) eine leitende Platte ist, die auf Steuererdpotential des Substrats (P) gehalten wird.

5. Stromkreismontageeinheit nach einem der Ansprüche 1 - 4, wobei
das Strommodul (51, 52) Schaltelemente (41 - 46) einer Wechselrichterschaltung (40) zum Umwandeln von Gleichstromspannung in Wechselstromspannung einschließt.

6. Stromkreismontageeinheit nach einem der Ansprüche 1 - 5, wobei
das Strommodul (51, 52) Schaltelemente (21 - 26) einer Gleichrichterschaltung 15 (20) zum Gleichrichten von Wechselstromspannung einer Wechselstromquelle (S) in Gleichstromspannung einschließt.

7. Motorantriebseinrichtung zum Antreiben eines Motors (M), umfassend:
eine Stromkreismontageeinheit (50) nach einem der Ansprüche 1 - 6; und
einen Motorsteuerungsbereich (12) zum Steuern des Motors (M) auf der Grundlage eines von der auf einem Substrat (P) der Stromkreismontageeinheit (50) montierten Detektionsschaltung (60) detektierten Stromwerts 20 oder Spannungswerts.

## Revendications

1. Unité de montage de circuit de puissance, comprenant :
un substrat (P) sur lequel un module de puissance (51, 52) est monté ;
un dissipateur thermique (53) pour dissiper la chaleur provenant des modules de puissance (51, 52), qui est fixé à des surfaces des modules de puissance (51, 52) ;
un circuit de détection (60) pour détecter un courant ou une tension prédéterminés, qui est monté près des modules de puissance (51, 52) sur le substrat (P), l'unité de montage de circuit de puissance ; et
un élément de blindage électromagnétique (70) pour réaliser un blindage contre les ondes électromagnétiques générées en provenance du dissipateur thermique (53) vers le côté circuit de détection (60),
**caractérisée en ce que** :
le circuit de détection (60) est agencé de façon à être face au dissipateur thermique (53) avec le substrat (P) étant interposé entre le circuit de détection (60) et le dissipateur thermique (53); et
l'élément de blindage électromagnétique (70) est prévu entre une section de fixation (60a) du circuit de détection (60) du substrat (P) et le dissipateur thermique (53).

2. Unité de montage de circuit de puissance selon la revendication 1, dans laquelle
l'élément de blindage électromagnétique (70) est une plaque conductrice maintenue au potentiel de masse.

3. Unité de montage de circuit de puissance selon la revendication 1 ou 2, comprenant en outre :
un élément de support conducteur (72) pour supporter l'élément de blindage électromagnétique (70) sur le substrat (P),
dans laquelle l'élément de blindage électromagnétique (70) est connecté à la masse du substrat (P) à travers l'élément de support (72).

4. Unité de montage de circuit de puissance selon la revendication 1, dans laquelle
l'élément de blindage électromagnétique (70) est une plaque conductrice maintenue au potentiel de masse de commande du substrat (P).

5. Unité de montage de circuit de puissance selon l'une quelconque des revendications 1 à 4, dans laquelle
le module de puissance (51, 52) inclut des éléments de commutation (41-46) d'un circuit inverseur (40) pour convertir une tension CC en tension CA.

6. Unité de montage de circuit de puissance selon l'une quelconque des revendications 1 à 5, dans laquelle
le module de puissance (51, 52) inclut des éléments de commutation (21-26) d'un circuit redresseur 15 (20) pour redresser une tension CA d'une source de puissance CA (S) en une tension CC.

7. Appareil d'entraînement de moteur pour entraîner un moteur (M), comprenant :
une unité de montage de circuit de puissance (50) selon l'une quelconque des revendications 1 à 6 ; et
une section de commande de moteur (12) pour commander le moteur (M) sur la base d'une valeur de courant 20 ou d'une valeur de tension détectée dans un circuit de détection (60) monté sur un substrat (P) de l'unité de montage de circuit de puissance (50).
